# Europäisches Patentamt

## European Patent Office

## Office européen des brevets

(11) Veröffentlichungsnummer: **0 010 682**
**A1**

(12) ## EUROPÄISCHE PATENTANMELDUNG

(21) Anmeldenummer: **79103992.8**

(22) Anmeldetag: **16.10.79**

(51) Int. Cl.³: **H 04 B 9/00,** G 08 C 23/00,
G 01 R 15/07

(30) Priorität: **27.10.78 SE 7811165**

(43) Veröffentlichungstag der Anmeldung: **14.05.80**
**Patentblatt 80/10**

(84) Benannte Vertragsstaaten: **CH DE FR GB IT**

(71) Anmelder: **ASEA AB, S-721 83 Västeras (SE)**

(72) Erfinder: **Morgan, Adolfsson, Dipl.-Ing., Sigfrid
Edströms Gata 86, S-724 66 Västeras (SE)**
Erfinder: **Torgny, Brogardh, Platverksgatan 140,
S-724 74 Västeras (SE)**

(74) Vertreter: **Boecker, Joachim, Dr.-Ing.,
Rathenauplatz 2-8, D-6000 Frankfurt a.M. 1 (DE)**

(54) **Übertragungsgerät zur Übertragung von Signalen über eine optische Verbindung.**

(57) Ein Gerät zur Übertragung eines Signals, z. B. des Ausgangssignals eines Meßgebers, über eine gewisse Entfernung und/oder auf ein anderes elektrisches Potentialniveau. Das Übertragungsgerät besteht aus einem Sender (S) und einem Empfänger (M), die über eine optische Verbindung miteinander verbunden sind. Der Sender enthält Glieder (2–7, 31, 32) zur Kombination von eingehenden Meßsignalen ($U_{in}$) mit Sollwertsignalen ($V_{ref}$) zu zwei verschiedenen Signalen, die über je einen von zwei parallelen optischen Kanälen (8, 9) zum Empfänger übertragen werden. Der Empfänger enthält Anordnungen zur Entgegennahme der beiden übertragenen Signale und zur Regelung der Verstärkung in den beiden Übertragungskanälen. Durch diese Regelung werden Parametervariationen in den beiden Kanälen und den zugehörigen Bauelementen ausgeglichen. Der Empfänger enthält außerdem Glieder, die aus den beiden übertragenen Signalen des Ausgangssignal ($U_{ut}$) des Übertragungsgerätes bilden, das von dem Eingangssignal des Senders abhängig ist.

EP 0 010 682 A1

Patentanwalt und Rechtsanwalt
Dr.-Ing. Dipl.-Ing. Joachim B o e c k e r

6 Frankfurt Main 1  5. 10. 1979
Rathenauplatz 2 - 8  B/th 20 716 PE
Telefon: (06 11) * 28 23 55
Telex: 4 189 066 itax d

A S E A   AB, Västeras/Schweden

## Übertragungsgerät zur Übertragung von Signalen über eine optische Verbindung

Die Erfindung betrifft ein Übertragungsgerät zur Übertragung von Signalen über eine optische Verbindung gemäß dem Oberbegriff des Anspruches 1.

Es ist bekannt, daß Meßsignale und andere Signale über eine optische Verbindung übertragen werden können. Eine solche Verbindung besteht aus einem Lichtsender, lichtübertragenden Gliedern und lichtmessenden Gliedern. Der Lichtsender enthält in geeigneter Weise Glieder zur Modulation des ausgesandten Lichtes, so daß das ausgesandte Licht Informationen über den Istwert des Übertragungssignals enthält. Das lichtübertragende Glied, welches aus einem oder mehreren Lichtleitern (optische Faser) bestehen kann, überträgt Lichtsignale auf das lichtmessende Glied, in welchem die Information über das Übertragungssignal in ein geeignetes Signal, beispielsweise in eine dem Übertragungssignal proportionale elektrische Spannung umgewandelt wird. Ein Übertragungsgerät dieser Art hat mehrere Vorteile. Man erhält automatisch eine galvanische Trennung zwischen Sender und Empfänger, die daher auf ganz verschiedenen elektrischen Potentialen

/2

- 2 -

liegen können. Die optische Verbindung ist gegenüber
Störungen durch elektromagnetische Felder völlig unempfindlich. Außerdem können keine Funken oder Kurzschlüsse auftreten, was beispielsweise in einer explosionsgefährdeten Umgebung von großem Wert ist.

Bei einem Übertragungsgerät der genannten Art ist es
wichtig, den Leistungsverbrauch im Sender möglichst
klein zu halten, da die Energieversorgung des Senders
bei größerem Energiebedarf häufig sehr kompliziert und
kostspielig ist, und zwar beispielsweise dann, wenn der
Sender auf einem hohen elektrischen Potential liegt.

Bei Messungen, die auf hohem Potential vorgenommen werden
müssen, möchte man nach Möglichkeit auf die bisher üblichen Strom- und Spannungswandler für hohe Spannungen
verzichten. Es entsteht dann jedoch das Problem, die
erforderliche Energie vom Empfänger auf die Senderseite
zu übertragen.

In der älteren europäischen Patentanmeldung 79 103 445.7
wird ein Übertragungsgerät zur Übertragung eines Meßsignals von einem Geber über einen gewissen Abstand
und/oder einen gewissen Potentialunterschied beschrieben.
Im Anschluß an den Geber ist ein Sender angeordnet, der
mittels einer optischen Verbindung mit einem Empfänger
verbunden ist. Auf der Senderseite befinden sich vergleichende Glieder, die Meßsignale mit einem vom Empfänger
übertragenen Rückführungssignal vergleichen. Das Vergleichsergebnis wird zum Empfänger übertragen, wo es einen
Regler steuert, dessen Ausgangssignal sowohl das Rückführungssignal als auch das Ausgangssignal des Übertragungsgeräts darstellt. Das Übertragungsgerät enthält
außerdem Glieder zum automatischen Konstanthalten der
Verstärkung in der Übertragungsverbindung für das Rückführungssignal. Diese Anordnung stellt eine Lösung der

/3

- 3 -

vorgenannten Probleme dar, und da nur wenige Fehlersignale vom Sender zum Empfänger gesandt werden, ist
die Dynamik dieser Übertragung niedrig. Die Dynamik
der gesamten Übertragung wird ganz von der Dynamik in
der Übertragung des Rückführungssignals vom Empfänger
zum Sender bestimmt.

Der Erfindung liegt die Aufgabe zugrunde, eine Anordnung
der eingangs genannten Art zu entwickeln, bei der die
oben genannten Probleme für den Fall gelöst sind, daß
auf Seiten des Senders Zugang zu einer gewissen Leistung
besteht. Dabei soll auch eine gewisse Dynamik auf der
Senderseite vorhanden sein.

Zur Lösung dieser Aufgabe wird ein Übertragungsgerät
nach dem Oberbegriff des Anspruches 1 vorgeschlagen,
welches erfindungsgemäß die im kennzeichnenden Teil des
Anspruches 1 genannten Merkmale hat.

Vorteilhafte Weiterbildungen der Erfindung sind in den
Unteransprüchen genannt.

Durch die Erfindung erhält man eine betriebssichere und
einfache Anordnung mit verhältnismäßig wenigen lichtübertragenden Fasern und einer einfachen Elektronik.

Anhand der in den Figuren gezeigten Ausführungsbeispiele
soll die Erfindung näher erläutert werden. Es zeigen:

Fig. 1 ein optisch gekoppeltes analoges Übertragungsgerät gemäß der Erfindung, bei dem
das Ausgangssignal durch Differenzbildung
zwischen den übertragenen optischen Signalen
gebildet wird,

Fig. 2 eine alternative Anordnung zur Linearisierung
der Übertragung, bei der der Leistungsbedarf

/4

- 4 -

auf der Senderseite niedriger ist,
Fig. 3 ein optisch gekoppeltes analoges Übertragungsgerät, bei dem das Ausgangssignal durch Quotientenbildung gewonnen
wird.

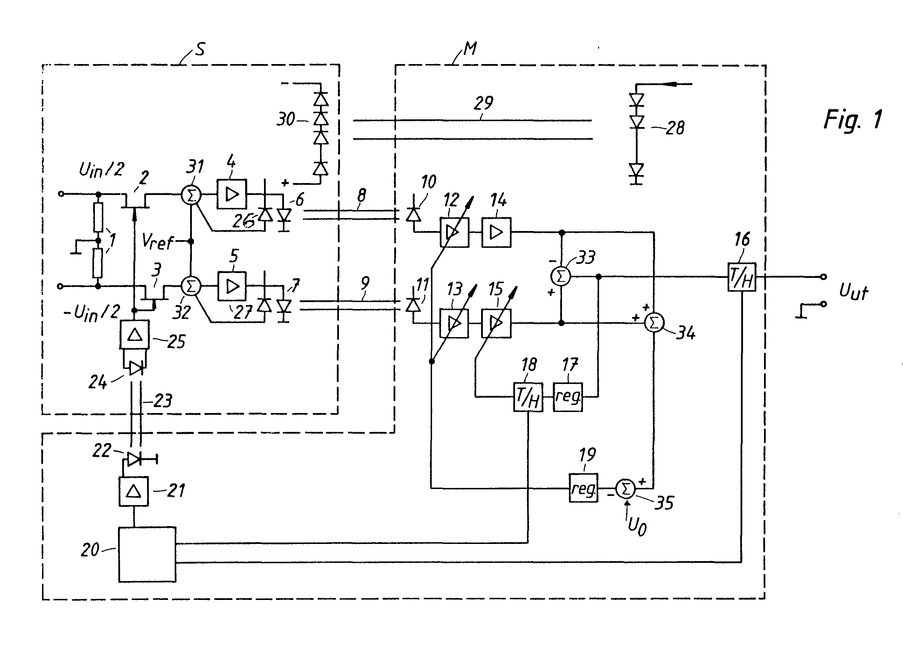

Figur 1 zeigt ein Übertragungsgerät zur Übertragung
eines analogen elektrischen Signals über eine optische
Verbindung. Das Meßgerät umfaßt einen Sender S, dem das
zu übertragende Signal als Eingangssignal $I_{in}$ zugeführt
wird, und einen Empfänger M, an dem das übertragene Signal
als Ausgangssignal $U_{ut}$ abgenommen wird. Sender und
Empfänger sind über mindestens zwei Lichtleiter 8, 9
miteinander verbunden. Der Abstand zwischen Sender und
Empfänger kann mehrere Kilometer betragen, und Sender
und Empfänger können auf verschiedenen elektrischen
Potentialen liegen.

Sender und Empfänger können aber auch unmittelbar nebeneinander angeordnet werden, z. B. dann, wenn nur ein
kleiner Potentialunterschied zu überbrücken ist. In diesem Falle können die Lichtleiter einschließlich der
zugehörigen Leucht- und Fotodioden aus optoelektronischen Kopplungselementen bestehen.

Figur 1 zeigt also einen optisch gekoppelten, analogen
Meßverstärker, bei dem die Stabilisierung der analogen
Übertragung nach dem Brückenprinzip erfolgt. Das Eingangssignal $U_{in}$ wird symmetrisch zum Bezugspotential
zugeführt, wobei die Mitte des Spannungsteilers 1 auf
dem Bezugspotential liegt. Hierbei erhält man die Signale
$+U_{in}/2$ und $-U_{in}/2$. Das Signal $+U_{in}/2$ geht über ein analoges Schaltglied, den Feldeffekttransistor 2, zu einem
Summierungsglied 31, wo dieses Signal mit einer Bezugsspannung $V_{ref}$ von einer Konstantspannungsquelle addiert
wird. Das zusammengesetzte Signal $(+U_{in}/2 + V_{ref})$ geht

- 5 -

auf den Eingang des Verstärkers 4. In entsprechender Weise erhält man ein zusammengesetztes Signal $(-U_{in}/2 + V_{ref})$ vom Summierungsglied 32, nachdem $-U_{in}/2$ den Feldeffekttransistor 3 passiert hat. Das Signal wird dem Verstärker 5 zugeführt.

Die beiden somit kombinierten Signale $+U_{in}/2 + V_{ref}$ und $-U_{in}/2 + V_{ref}$ werden in je einen von zwei parallelen Signalkanälen gegeben, die aus den Verstärkern 4 bzw. 5, den Leuchtdioden 6 bzw. 7, den beiden optischen Kanälen 8 bzw. 9 (lichtleitende Faser), den Fotodioden 10 bzw. 11, den regelbaren Fotoverstärkern 12 bzw. 13 und den Verstärkern 15 bzw. 14 bestehen. Über Lichtrückführungskreise, welche die Fotodioden 26 und 27 enthalten, werden die Nichtlinearitäten der Leuchtdioden 6 und 7 kompensiert. Die Signalkanäle unterscheiden sich dadurch, daß der Verstärker 14 im oberen Kanal in Figur 1 eine feste Verstärkung hat, während die Verstärkung des Verstärkers 15 in dem unteren Kanal variabel ist. Der Übertragungsablauf ist zeitlich in zwei Intervalle unterteilt (zeitmultiplext), nämlich ein Intervall, in dem die Übertragungseigenschaften der beiden Kanäle einander angepaßt werden, und ein Intervall, in dem die Übertragung des Meßsignals selbst erfolgt. Die Signalwege werden im Sender S über die als Schalter arbeitenden Feldeffekttransistoren 2 und 3 mittels einer Steuerlogik 20 gesteuert (siehe weiter unten).

Während des Anpassungs- oder Ausbalancierungsintervalls sind die Feldeffekttransistoren 2 und 3 nichtleitend, so daß die Eingangssignale für die beiden Kanäle gleichermaßen den Wert $V_{ref}$ haben.

Die an den Verstärkern 14 und 15 abgegriffenen Ausgangssignale der Signalkanäle werden im Summierungsglied 33 miteinander verglichen. Ein eventuell auftretendes Differenzsignal bedeutet, daß die Parameter der beiden Signalkanäle sich unterschiedlich verändert haben, z. B.

/6

Alterung der Dioden, veränderte Biegung der lichtleitenden Fasern, Unterschiede bei den variablen Verstärkern usw. Das Differenzsignal wird einem Regler 17
zugeführt, der über das Folge- und Halteglied 18
("track and hold"-Glied) die Verstärkung des variablen
Verstärkers 15 steuert. Unter einem Folge- und Halteglied versteht man ein solches, welches einen einmal
am Eingang liegenden Signalwert speichert, bis zu einem
späteren Zeitpunkt ein Befehl gegeben wird, das in
diesem Zeitpunkt am Eingang liegende Signal zu speichern. Durch die Ausbalancierung der beiden Signalkanäle erreicht man, daß die gesamte Übertragungscharakteristik in den beiden Kanälen 6 - 10 und 7 - 11
trotz Parametervariationen in den optischen Bauteilen
gleichbleibt. In dem Summierungsglied 34 wird die Summe
der Ausgangssignale der Verstärker 14 und 15 gebildet.
Diese wird in einem Summierungsglied 35 mit einer
konstanten Spannung $U_0$ verglichen. Der am Ausgang des
Summierungsgliedes 35 erscheinende Differenzwert steuert
über einen Regler 19 den Verstärkungsgrad der Verstärker
12 und 13. Durch diese Anordnung werden die Parametervariationen kompensiert, die in beiden Kanälen gleichzeitig auftreten. Während des Meßintervalls wird die
Verstärkung des Verstärkers 15 dadurch konstant gehalten,
daß das Folge- und Halteglied 18 in Haltelage arbeitet.
Den Verstärkern 4 bzw. 5 werden die Spannungen $V_{ref} +
U_{in}/2$ bzw. $V_{ref} - U_{in}/2$ zugeführt. Dieses Zeitintervall
wird Meßintervall genannt zum Unterschied von dem vorstehend beschriebenen Zeitintervall, das Kalibrierungsintervall genannt wird.

Während des Meßintervalls erhält man das Ausgangssignal
als Differenz aus den Ausgangssignalen der Verstärker
14 und 15. Durch das Folge- und Halteglied 16 wird das
Ausgangssignal während des Kalibrierungsintervalles
konstant gehalten. Die Folge- und Halteglieder 16 und 18
werden von der Steuerlogik 20 gesteuert, die auch die

/7

- 7 -

als Schalter arbeitenden Feldeffekttransistoren 2 und 3 über einen Verstärker 21, eine Leuchtdiode 22, eine lichtleitende Faser 23 und einen Fotostromverstärker 25 steuert.

Die für den Betrieb des Senders erforderliche Leistung wird auf optischem Wege übertragen. Zu diesem Zweck ist in Figur 1 eine Leuchtdiodenkette 28 vorhanden, welche den sie durchströmenden Strom in Licht umwandelt. Anstelle der Leuchtdioden können auch Halbleiterlaser verwendet werden. Das Licht wird durch eine oder mehrere lichtleitende Fasern 29 auf die in Reihe geschalteten Fotodioden 30 geleitet, deren Ausgangsspannung die Elektronik des Senders speist.

Während des Kalibrierungsintervalles, in welchem die Feldeffekttransistoren 2 und 3 nichtleitend sind, erscheint am Ausgang des Summierungsgliedes 33 folgendes Signal:

$$k_1 \cdot V_{ref} - k_2 \cdot V_{ref} = (k_1 - k_2) V_{ref}$$

Dabei sind $k_1$ und $k_2$ die resultierenden Verstärkungsfaktoren der beiden Kanäle.

Der Regler 17 stellt sich so ein, daß $k_1 - k_2 = 0$ und $k_1 = k_2 = k$.

Der Regler 19 stellt sich so ein, daß

$$k_1 \cdot V_{ref} + k_2 \cdot V_{ref} = U_0$$

$$(k_1 + k_2) V_{ref} = U_0$$

$$2k \cdot V_{ref} = U_0$$

- 8 -

$$k = \frac{U_0}{2 \cdot V_{ref}}$$

Während des Meßintervalls (2 und 3 sind leitend) erhält man folgendes Signal:

$$U_{ut} = k_1 \left(V_{ref} - \frac{U_{in}}{2}\right) - k_2 \left(V_{ref} + \frac{U_{in}}{2}\right) = k \cdot V_{ref}$$

$$- k \cdot \frac{U_{in}}{2} - k \cdot V_{ref} - k \cdot \frac{U_{in}}{2} = - k \cdot U_{in}$$

$$U_{ut} = - \frac{U_0}{2 \cdot V_{ref}} \cdot U_{in}$$

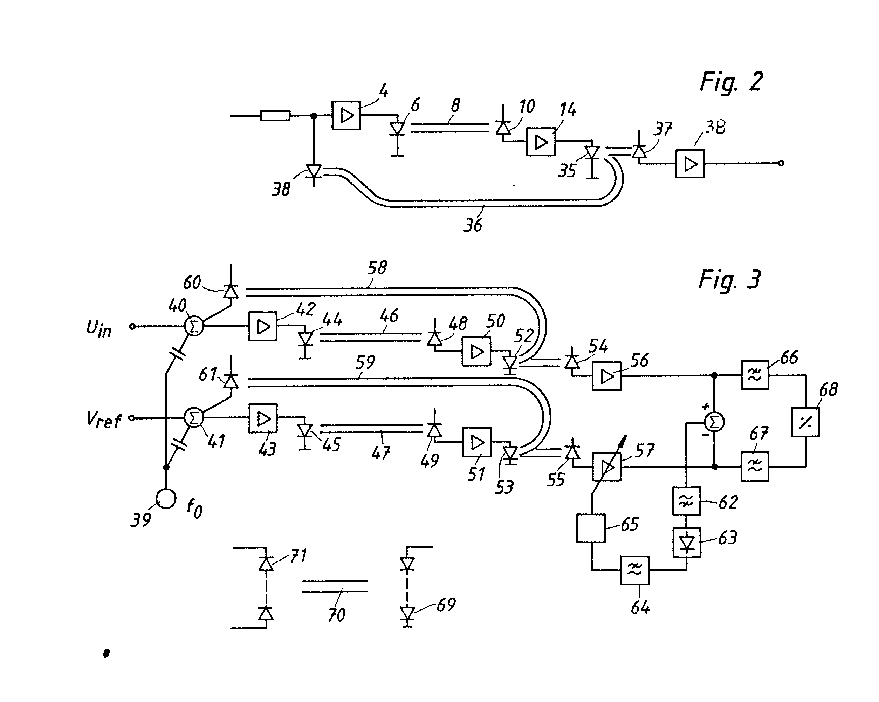

Figur 2 zeigt eine Anordnung, bei der man bei Leistungsmangel im Sender S die direkte Rückführung des Lichtes von der Leuchtdiode 6 über eine Fotodiode 26 durch eine faseroptische Rückführung ersetzt. Zur Rückführung wird eine zusätzliche lichtleitende Faser 36 verwendet. Die Rückführung erfolgt über den Empfänger, in welchem das Rückführungssignal verstärkt wird. Auf diese Weise erhält man einen Sender (Gebermodul), dessen Leistungsbedarf geringer ist.

Das Licht der Fotodiode 6 wird über eine lichtleitende Faser 8 auf die Fotodiode 10 geleitet, der ein Verstärker 14 nachgeschaltet ist, der eine Leuchtdiode 35 speist. Das Licht der Leuchtdiode 35 dient zum einen als Ausgangssignal über eine Fotodiode 37 mit nachgeschaltetem Verstärker 38 und zum anderen als Rückführungssignal über die lichtleitende Faser 36 und die Fotodiode 38.

In Figur 1 können die als analoge Schalter arbeitenden Feldeffekttransistoren 2 und 3 zusammen mit der Fotodiode 24 und dem Fotostromverstärker 25 durch Fotofeldeffekttransistoren ersetzt werden, die direkt durch das von der lichtleitenden Faser 23 gelieferte Licht gesteuert werden.

- 9 -

Das Übertragungsgerät gemäß Figur 3 ist ein optisch gekoppelter, analoger Meßverstärker, bei dem die Stabilisierung der Übertragung nach dem Brückenprinzip erfolgt. Zu jedem der beiden Signale, dem Eingangssignal $U_{in}$ und der Bezugsspannung $V_{ref}$, wird dasselbe vom Oszillator 39 gelieferte Wechselsignal mit der Frequenz $f_0$ in den Summierungsgliedern 40 und 41 an den Eingängen der beiden Verstärker 42 und 43 addiert. Die Summensignale werden über zwei parallele Kanäle übertragen, die aus den Verstärkern 42 bzw. 43, den Leuchtdioden 44 bzw. 45, den lichtleitenden Fasern 46 bzw. 47, den Fotodioden 48 bzw. 49, den Fotostromverstärkern 50 bzw. 51, den Leuchtdioden 52 bzw. 53, den Fotodioden 54 bzw. 55 und den Verstärkern 56 bzw. 57 bestehen (vergleiche 14 und 15 in Fig. 1). Mit der Ausnahme, daß der Verstärker 56 eine konstante und der Verstärker 57 eine steuerbare Verstärkung hat, sind beide Kanäle gleich. Um die Linearität der Übertragung zu verbessern, wird ein Teil des Lichtes der Leuchtdioden 52 und 53 über je eine lichtleitende Faser 58 und 59 auf je eine Fotodiode 60 und 61 an den Summierungspunkt 40 bzw. 41 vor den Verstärkern 42 und 43 zurückgeführt. Das Licht wird in den Fotodioden 60 und 61 in elektrische Signale umgewandelt und bildet auf diese Weise eine linearisierende Rückführung. Die Differenz aus den Ausgangssignalen der Verstärker 56 und 57 passiert ein Hochpaßfilter 62, welches nur solche Komponenten des Signals durchläßt, deren Frequenz $f_0$ oder größer als $f_0$ ist. Dieser Teil des Signals wird im Gleichrichter 63 gleichgerichtet, im Tiefpaßfilter 64 tiefpaßgefiltert und dann einem Regler 65 zugeführt, welcher die Verstärkung des steuerbaren Verstärkers 57 steuert. Die Verstärkung des Verstärkers 57 wird derart gesteuert, daß Abweichungen zwischen den Übertragungscharakteristiken der beiden Kanäle beseitigt werden. Die Ausgangssignale der beiden Kanäle passieren die Tiefpaßfilter 66 und 67, durch welche

/10

die Komponenten mit der Frequenz $f_0$ oder höher herausgefiltert werden. In einem Divisionsglied 68 wird der Quotient aus den Ausgangssignalen der beiden Tiefpaßfilter gebildet. Dieser Quotient dient als Ausgangssignal der Übertragung. Auf diese Weise ist das Ausgangssignal gegenüber solchen Variationen der Übertragungscharakteristik kompensiert, die in beiden Kanälen auftreten. Das Signal mit der Frequenz $f_0$, das zur Ausbalancierung der Übertragungscharakteristiken beider Kanäle dient, wird von einem Oszillator 39 auf der Senderseite gebildet. Die Energieversorgung des Senders wird auf optischem Wege vorgenommen. Zu diesem Zweck wird das von den Leuchtdioden 69 oder alternativ von Halbleiterlasern gebildete Licht über eine oder mehrere optische Fasern 70 auf in Reihe geschaltete Fotodioden 71 übertragen, welche die Speisespannung für die Elektronik des Senders liefern.

Die vorstehend beschriebenen Ausführungsbeispiele können im Rahmen des offenbarten allgemeinen Erfindungsgedankens in vielfacher Weise variiert werden.

Patentanwalt und Rechtsanwalt
Dr.-Ing. Dipl.-Ing. Joachim B o e c k e r

6 Frankfurt/Main 1 , 5.10.1979
Rathenauplatz 2-8      B/th 20 716 PE
Telefon: (06 11) *28 23 55
Telex: 4 189 066 itax d

- 11 -

Patentansprüche:

1. Übertragungsgerät zur Übertragung von Signalen über eine optische Verbindung, bestehend aus einem Sender und einem Empfänger an den Enden der optischen Verbindung, dadurch gekennzeichnet, daß der Sender Glieder (2 - 7) enthält zur Kombination von Eingangssignalen ($U_{in}$) mit Sollwertsignalen ($V_{ref}$) zu mindestens zwei verschiedenen Signalen, die über mindestens zwei parallele optische Kanäle (8, 9) zum Empfänger übertragen werden, und daß der Empfänger solche Anordnungen zur Aufnahme und Verarbeitung der übertragenen Signale hat, durch welche aus diesen Signalen Ausgangssignale ($U_{ut}$) gebildet werden, die von den Eingangssignalen ($U_{in}$) abhängig und von Veränderungen und Instabilitäten in den optischen Kanälen und der zugehörigen Optoelektronik unabhängig sind.

2. Übertragungsgerät nach Anspruch 1, dadurch gekennzeichnet, daß die Eingangssignale ($U_{in}$) und die Sollwertsignale ($V_{ref}$) elektrische Signale sind und daß die kombinierten Signale über Leuchtdioden (6, 7) in optische Signale zur Übertragung über die optischen Kanäle (8, 9) zum Empfänger (M) umgewandelt werden.

3. Übertragungsgerät nach Anspruch 1 oder 2, dadurch gekennzeichnet, daß der Empfänger Anordnungen enthält, in denen die Sollwertsignale von den Meßsignalen separiert werden.

4. Übertragungsgerät nach einem der vorhergehenden Ansprüche, dadurch gekennzeichnet, daß in mindestens einem optischen Kanal ein regelbarer Verstärker (15)

/12

5. 10. 1979
20 716 PE

0010682

- 12 -

oder ein regelbares Dämpfungsglied angeordnet ist,
dessen Verstärkung/Dämpfung von der Differenz
zwischen den Signalen von mindestens zwei der Kanäle
unter Berücksichtigung mindestens eines Sollwertsignals gesteuert wird.

5. Übertragungsgerät nach einem der vorhergehenden Ansprüche, dadurch gekennzeichnet, daß die über die
optischen Kanäle (8, 9; 46, 47) beförderten Sollwert-
und Meßsignale zeit- oder frequenzmultiplext sind.

6. Übertragungsgerät nach Anspruch 5, dadurch gekennzeichnet, daß ein Sollwertsignal zwei Kanälen zugeführt wird, daß die Differenz aus den
über die Kanäle übersandten Signalen gebildet
wird und der von den Sollwertsignalen gebildete Anteil mit Hilfe von Folge- und Haltegliedern (Zerhackergliedern) (18) oder Filtern (62) separiert
wird und daß dieser Anteil einen Regler (17, 65)
derart steuert, daß der zu einem Kanal gehörende,
regelbare Verstärker (15, 57) derart eingestellt
wird, daß unterschiedliche Änderungen von Parametern
in den beiden Kanälen kompensiert werden.

7. Übertragungsgerät nach einem der vorhergehenden Ansprüche, dadurch gekennzeichnet, daß die übertragenen
Meß- ($U_{in}$) und Sollwertsignale ($V_{ref}$) im Empfänger
einem Quotientenbilder (68) zugeführt werden, welcher
den Quotienten aus den beiden Signalen bildet.

8. Übertragungsgerät nach einem der vorhergehenden Ansprüche, dadurch gekennzeichnet, daß zu jedem Kanal
ein regelbarer Verstärker (12, 13) gehört.

9. Übertragungsgerät nach Anspruch 8, dadurch gekennzeichnet, daß die über die optischen Kanäle über-

/13

- 13 -

tragenen Sollwertsignale durch Summenbildung (34) und Vergleich mit einem Bezugswert ($U_o$) dazu verwendet werden, die regelbaren Verstärker (12, 13) so zu steuern, daß eine Kompensation solcher Parametervariationen stattfindet, die in den verschiedenen Kanälen gleichzeitig auftreten.

10. Übertragungsgerät nach einem der vorhergehenden Ansprüche, dadurch gekennzeichnet, daß die Übertragung vom Sender zum Empfänger durch optisch rückgekoppelte Verstärker linearisiert ist.

11. Übertragungsgerät nach einem der vorhergehenden Ansprüche, dadurch gekennzeichnet, daß die Signale nach Passieren der optischen Kanäle verstärkt und aufgeteilt werden in einen ersten Teil zur Bildung des Ausgangssignals und einen zweiten Teil, der über je eine optische Verbindung (58, 59) zum Sender zurückgeführt wird.

12. Übertragungsgerät nach einem der vorhergehenden Ansprüche, dadurch gekennzeichnet, daß die Energieversorgung des Senders ganz oder teilweise auf optischem Wege über eine oder mehrere in Reihe geschaltete Fotodioden (71, 30) erfolgt.

13. Übertragungsgerät nach Anspruch 12, dadurch gekennzeichnet, daß die im Sender vorhandenen Anordnungen zur optoelektronischen Umwandlung mit auf optischem Wege zugeführter Energie gespeist werden, wobei die Energiezuführung mit gepulstem Licht erfolgt, das von einer oder mehreren Fotodioden (71) entgegengenommen wird, deren elektrisches Ausgangssignal über Transformatoren und Gleichrichter auf ein geeignetes Spannungsniveau umgewandelt wird.

/14

Fig. 1

Fig. 2

Fig. 3

**Europäisches Patentamt**

## EUROPÄISCHER RECHERCHENBERICHT

Nummer der Anmeldung

EP 79 10 3992

### EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | FR - A - 2 361 022 (SOCIETE NATIONALE INDUSTRIELLE AEROSPATIALE)<br><br>* Seite 4, Zeile 13 bis Seite 7, Zeile 20; Figur * | 1-4 |
| | -- | |
| | US - A - 4 070 572 (SUMMERHAYES)<br><br>* Spalte 1, Zeile 60 bis Spalte 4, Zeile 19; Figur 1 * | 1-4,10 |
| | -- | |
| | DE - A - 2 716 788 (SPINNER)<br><br>* Anspruche 1,9,10,14 * | 12,13 |
| | -- | |
| E | EP - A - 0 004 815 (THOMSON CSF)<br><br>* Seite 4, Zeile 11 bis Seite 6, Zeile 27; Figur 2 * | 1-4 |
| E | & FR - A - 2 423 093 | |
| | -- | |
| A | DE - A - 2 700 717 (COMPAGNIE GENERALE D'ELECTRICITE)<br><br>* Anspruch 1; Figur 1 * | 1 |
| | -- | |
| A | US - A - 3 666 956 (VON WILLISEN)<br><br>* Anspruch 1; Figur 2 * | |
| | ---- | |

**KLASSIFIKATION DER ANMELDUNG (Int.Cl. 3)**

H 04 B 9/00
G 08 C 23/00
G 01 R 15/07

**RECHERCHIERTE SACHGEBIETE (Int. Cl. 3)**

G 01 R 15/07
G 08 C 23/00
H 04 B 9/00
H 03 G 3/20
3/30

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angefuhrtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 21-01-1980 | WANZEELE |

EPA form 1503.1   06.78